# EUROPÄISCHE PATENTSCHRIFT

(11) **EP 0 425 440 B1**
(45) Veröffentlichungstag und Bekanntmachung des Hinweises auf die Patenterteilung: **17.11.1994**
(21) Anmeldenummer: 90810802.0
(22) Anmeldetag: 19.10.1990
(51) Int. Cl.: G03F 7/031

(54) **Verfahren zur Abstimmung der Strahlungsempfindlichkeit von photopolymerisierbaren Zusammensetzungen**
Method of adjusting the photosensitivity of photopolymerizable compositions
Méthode de mise au point de la photosensibilité de compositions photopolymérisables

(30) Priorität: 27.10.1989 CH 3901/89
(43) Veröffentlichungstag der Anmeldung: 02.05.1991
(73) Patentinhaber: CIBA-GEIGY AG, 4002 Basel (CH)
(72) Erfinder: Hofmann, Manfred, Dr., Ch-1723 Marly (CH); Klingert, Bernd, Dr., W-7854 Inzlingen (DE); Hunziker, Max, Dr., CH-3186 Düdingen (CH); Wiesendanger, Rolf, Dr., CH-4056 Basel (CH); Schulthess, Adrian, Dr., CH-1734 Tentlingen (CH); Bernhard, Paul, Dr., CH-Fribourg (CH)

(56) Entgegenhaltungen:
- DE-A- 3 208 659
- FR-A- 2 339 881
- US-A- 4 590 145

## Beschreibung

Die vorliegende Erfindung betrifft ein neues Verfahren zur Herstellung von photopolymerisierbaren Materialien durch Abstimmung der Strahlungsempfindlichkeit, sowie Verfahren zur Photopolymerisation unter Verwendung besagter Materialien.

Die Photopolymerisation von chemischen Verbindungen ist relativ teuer. Es hat daher nicht an Versuchen gefehlt, die Strahlungsenergie besser auszunutzen. Eine Möglichkeit zur Reduktion der Energiekosten besteht darin, bei der Polymerisation mehrere Emissionslinien einer Strahlungsquelle gleichzeitig zu verwenden. Dazu sind bereits Photoinitiatoren eingesetzt worden, die bei unterschiedlichen Wellenlängen wirksam sind. Solche Gemische sind beispielsweise in den EP-A-297,051, EP-A-313,007 und EP-A-321,827 beschrieben.

Bisher wurden Photopolymer-Formulierungen im allgemeinen in Form von dünnen Schichten, wie Klebefilmen, Lacken oder Druckfarben ausgehärtet. Dazu werden diese Schichten in der Regel mit Lichtquellen, die ein breitbandiges Spektrum emittieren, bestrahlt. Die Photoinitiatoren (Typen und Konzentration) werden dabei so ausgewählt, dass die Schicht teilweise durchstrahlt wird und möglichst rasch in ihrer ganzen Dicke aushärtet.

In jüngerer Zeit wurden neue Anwendungsgebiete für Photopolymer-Formulierungen erschlossen, bei denen die Photopolymerisation von Schichten mit einer hohen optischen Absorption eine kritische Rolle spielt. Ein Beispiel für solche Anwendungen ist die Herstellung von dreidimensionalen Objekten (im folgenden 3D Objekte genannt) mittels lithographischer Verfahren. Unter 3D Objekten sind im Rahmen dieser Beschreibung Objekte zu verstehen, deren Dimensionen nicht allein durch eine Schicht photopolymerisierten Materials einheitlicher Dicke vorgegeben sind.

Es hat sich gezeigt, dass bei der Härtung von Schichten polymerisierbarer Materialien mit einer hohen optischen Absorption Probleme auftreten, die in vorbekannten Systemen keine oder eine zu vernachlässigende Rolle spielen.

In eine Photopolymer-Formulierung eindringendes Licht besitzt eine charakteristische Eindringtiefe, da die jeweils darüberliegenden Anteile des polymerisierbaren Materials einen Teil des Lichtes absorbieren. Bei der Photopolymerisation wird nur Licht wirksam, das vom Photoinitiator im betreffenden Volumenanteil absorbiert worden ist. Man findet mit zumehmender Tiefe einen der Lichtintensität folgenden abnehmenden Polymerisationsgrad des photopolymerisierten Materials.

Beim Unterschreiten eines Grenzwertes der Lichtintensität findet im allgemeinen keine Gelierung des photopolymerisierbaren Materials mehr statt. Polymerisierbares Material mit einer hohen optischen Absorption ist also im allgemeinen direkt an der Oberfläche gehärtet, weist mit zunehmender Tiefe einen steigenden Anteil von geliertem Material auf und ist in noch grösserer Tiefe überhaupt nicht merklich verändert.

Für die Photopolymerisation von Schichten mit einer hohen optischen Absorption ist es von Vorteil, dass der Gradient des Polymerisationsgrades im Bereich des Ueberganges von praktisch unverändertem Material zu geliertem material möglichst steil verläuft.

Es wurde nun gefunden, dass dieser Gradient dann möglichst steil ist, wenn die Intensitätsabnahme des Lichtes in der Photopolymer-Formulierung einem einfachen Exponentialgesetz folgt.

Die Eindringtiefe von Licht in eine Photopolymer-Formulierung ist im allgemeinen stark wellenlängenabhängig, so dass bei der Bestrahlung mit mehreren unterschiedlichen Wellenlängen mit einem nicht-exponentiellen Abfall des Intensitätsverlaufes zu rechnen ist, wodurch der Gradient des Polymerisationsgrades weniger steil wird (im Vergleich zu einer Photopolymer-Formulierung mit einem einfachen exponentiellen Abfall des Intensitätsverlaufes).

Man beobachtet, dass das mathematische Produkt aus Eindringtiefe und Härtungsgrad (mechanische Festigkeit) des entstehenden Polymers bei der gleichzeitigen Verwendung mehrerer Photoinitiatoren (die bei unterschiedlichen Wellenlängen verschieden reaktiv sind) und Einstrahlung vergleichbarer Lichtenergie (pro Flächeneinheit) kleiner ist als bei der Verwendung eines Photoinitiators.

Es wurde jetzt ein Verfahren zur Abstimmung der Strahlungsempfindlichkeit von Photopolymer-Formulierungen gefunden, mit dem Zusammensetzungen bereitgestellt werden, worin der gewünschte Gradient des Polymerisationsgrades erzielt werden kann. Die Erfindung beruht auf der Erkenntnis, dass durch eine Variation der Mengen von mehreren Photoinitiatoren die Eindringtiefe des Lichtes verschiedener Wellenlängen gezielt beeinflusst werden kann. Damit kann ein gegebenes Photopolymersystem in einfacher Art und Weise an die jeweilige Applikation und Lichtquelle angepasst werden.

Die vorliegende Erfindung betrifft ein Verfahren zur Herstellung von photopolymerisierbaren Zusammensetzungen, wobei die photopolymerisierbaren Zusammensetzungen durch Einstrahlung von Emissionslinien unterschiedlicher Wellenlänge einer UV/VIS-Laserlichtquelle photopolymerisiert werden können und eine photopolymerisierbare Verbindung und im allgemeinen mindestens zwei Photoinitiatoren enthalten, dadurch gekennzeichnet, dass durch Abstimmung der Strahlungsempfindlichkeit das Verhältnis der Konzentrationen der einzelnen Photoinitiatoren so ausgewählt wird, dass die photopolymerisierbare Zusammensetzung für Strahlung der verschiedenen Emissionslinien, welche die Photopolymerisation bewirken, praktisch die gleiche optische Dichte aufweist.

Der Begriff "gleiche optische Dichte (bei verschiedenen Wellenlängen)" wird in an sich bekannter Weise immer auf eine Dicke der absorbierenden Zusammensetzung bezogen. Systeme mit gleichen Extinktionskoeffizienten (bei gleichen Wellenlängen und gleichen Konzentrationen) besitzen also bei unterschiedlichen Dicken der absorbierenden Zusammensetzung auch unterschiedliche optische Dichten. Bei gleichen Dicken der absorbierenden Zusammensetzung sind die optischen Dichten solcher Systeme allerdings gleich. Eine Definition des Begriffes "optische Dichte" wird weiter unten bei Formel (2) gegeben.

Die für ein ausgewähltes Polymersystem erforderliche optische Dichte bei den die Polymerisation bewirkenden Wellenlängen der Emissionslinien wird unter anderem von der gewünschten Eindringtiefe der Strahlung (bei der betreffenden Wellenlänge und bei vorgegebener Strahlungsintensität I₀) abhängen.

Der Begriff "Eindringtiefe" soll im Rahmen dieser Beschreibung bedeuten, dass das Licht so tief in die photopolymerisierbare Zusammensetzung eindringt, dass sich eine für die betreffende Anwendung ausreichende Schichtdicke an polymerisiertem Material bildet. Dabei handelt es sich um Material, das gegenüber dem vorgelegten Material verändert ist; es kann sich dabei also um polymerisiertes material handeln, das einen bestimmten Anteil an geliertem Material enthält, oder es handelt sich um praktisch nur geliertes Material. Die jeweils nötige Schichtdicke und der Grad der Veränderung des polymerisierbaren Materials werden gemäss dem jeweiligen Anwendungszweck ausgewählt.

Der Begriff "praktisch die gleiche optische Dichte" soll im Rahmen dieser Beschreibung bedeuten, dass sich die Eindringtiefen von Licht verschiedener Wellenlängen nur in einem solchen Ausmass unterscheiden, dass eine für die betreffende Anwendung ausreichend definierte untere Grenze der photopolymerisierten Schicht erhalten wird; das bedeutet in der Regel, dass die optischen dichten [Definition siehe weiter unten bei Formel (2)] der Mischung bei den verschiedenen Wellenlängen sich beispielsweise nur um +/- 20 %, bezogen auf das arithmetische Mittel der optischen Dichten, unterscheiden.

Vorzugsweise wird das Mengenverhältnis der Photoinitiatoren so gewählt, dass die optischen Dichten der photopolymerisierbaren Zusammensetzung für Strahlung der verschiedenen Emissionslinien, welche die Photopolymerisation bewirken, gleich sind.

Die folgenden Ueberlegungen erläutern das erfindungsgemässe Verfahren im einzelnen:

Die Intensität des eingestrahlten Lichtes nimmt im allgemeinen mit zunehmender Tiefe der zu polymerisierenden Schicht exponentiell ab. Die Stärke dieser Abnahme ist in der Regel von der Wellenlänge der verwendeten Strahlung und vom jeweils eingesetzten Photoinitiator abhängig. Der Verlauf der Strahlungsintensität als Funktion der Dicke der durchstrahlten Schicht beträgt

I = I₀ · 10^{-εcd} (1).

Dabei ist I₀ die Intensität der auf die Oberfläche auftreffenden Strahlung, ε ist der Extinktionskoeffizient, c ist die Konzentration der absorbierenden Verbindung, d ist die Dicke der durchstrahlten Schicht und I die Intensität der Strahlung nach Durchdringen der Schicht. Der Begriff A = lg(I₀/I) ist die bereits weiter oben erwähnte optische Dichte der Zusammensetzung. Es gilt also

A = εcd (2).

Sollen zur Photopolymerisation mehrere Wellenlängen ausgenutzt werden, so folgt die Intensitätsverteilung der Strahlung in der Tiefe in der Regel nicht mehr einem einfachen Exponentialgesetz, sondern sie zeigt einen multiexponentiellen Abfall.

Die Abstimmung des Mengenverhältnisses der einzelnen Photoinitiatoren für die erfindungsgemässe Zusammensetzung wird am Beispiel einer Zusammensetzung gezeigt, die durch Bestrahlung mit zwei Emissionslinien gehärtet wird.

Vorgegeben sind die Wellenlängen der Emissionslinien λ₁ und λ₂, bei denen die Zusammensetzung gehärtet werden soll. Die für den jeweiligen Anwendungszweck gewünschte Dicke der durchstrahlten Schicht von photopolymerisierbarem Material sei d. Die durch den Photoinitiator 1 hervorgerufene optische Dichte der Zusammensetzung für eine gewünschte Dicke d betrage bei einer vorgegebenen Wellenlänge A₁ = A₁(λ). Für den Photoinitiator 2 gilt entsprechend A₂ = A₂(λ). Der Extinktionskoeffizient der Zusammensetzung bei λ₁ betrage ε₁ bzw. bei λ₂ betrage ε₂. Der Photoinitiator 1 liege in einer Konzentration c₁ vor und der Photoinitiator 2 liege in einer Konzentration c₂ vor. Gesucht sind die Konzentrationen und das Verhältnis der Konzentrationen c₁ : c₂ der beiden Photoinitiatoren.

Ausgehend von der obigen Formel gelten für die optische Dichte A der Mischung bei λ₁ bzw. bei λ₂ die folgenden Zusammenhänge (dabei wird angenommen, dass bei diesen Wellenlängen nur die beiden Photoinitiatoren einen Beitrag zur Absorption beisteuern):

A(λ₁) = A₁(λ₁) + A₂(λ₁) (3)

und

A(λ₂) = A₁(λ₂) + A₂(λ₂) (4).

Die durch die Photoinitiatoren 1 bzw. 2 hervorgerufene optische Dichte A₁ bzw. A₂ der Zusammensetzung beträgt:
A₁(λ) = ε₁(λ)c₁d (5)

und

A₂(λ) = ε₂(λ)c₂d (6).

Kombination der Gleichungen (3) und (5) bzw. (4) und (6) führt zu den folgenden Gleichungen, welche die optische Dichte der Zusammensetzung bei λ₁ bzw. bei λ₂ in Abhängigkeit der Konzentrationen der Photoinitiatoren und deren Extinktionskoeffizienten darstellen: 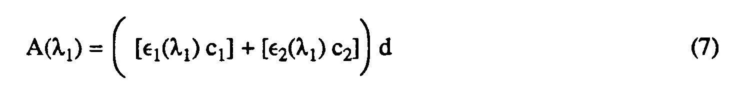
und

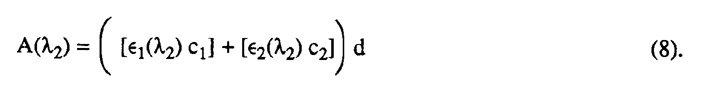

Auflösung der Gleichungen (7) und (8) nach c₁ bzw. nach c₂ führt zu den Gleichungen (9) und (10), worin c₁ als Funktion von c₂ bzw. c₂ als Funktion von c₁ dargestellt wird: 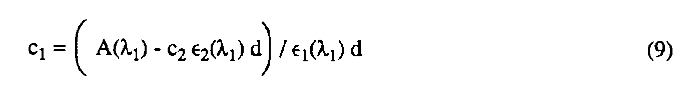
und

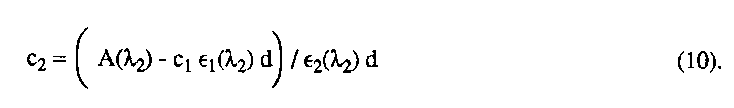

Zur Ableitung eines Gleichungssystems, worin c₁ bzw. c₂ lediglich durch vorgegebene Grössen dargestellt werden, kombiniert man die Gleichungen (7) mit (10) bzw. (8) mit (9) und löst nach c₁ bzw. nach c₂ auf. Man erhält so die gesuchte Abhängigkeit von c₁ in Form von Gleichung (11) und von c₂ in Form von Gleichung (12):

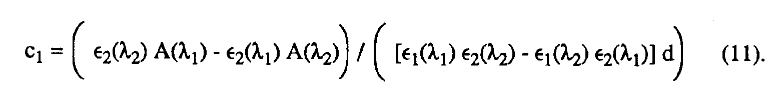

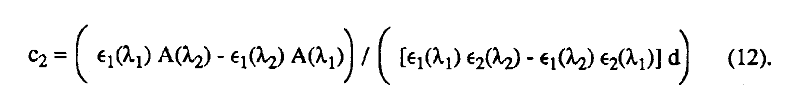

Für die zu verwendende Harzformulierung sind ε₁(λ₁), ε₁(λ₂), ε₂(λ₁) und ε₂(λ₂) bekannt. Die Bedingung A(λ₁) = A(λ₂), der Wert von A und der Wert von d werden vorgegeben. Aus den obigen Formeln lässt sich als für jeden der beiden Photoinitiatoren ein bestimmter Wert für c₁ und c₂ und somit ein Verhältnis der Konzentrationen für diese Photoinitiatoren ermitteln.

Diese Auswahlkriterien sind auf Zusammensetzungen übertragbar, die mehr als zwei Photoinitiatoren enthalten und/oder die auf mehr als zwei Wellenlängen abgestimmt sind. In diesen Fällen geht man von verallgemeinerten Gleichungen (3) bzw. (4) und (5) bzw. (6) aus und bestimmt daraus die verschiedenen Konzentrationen cᵢ der einzelnen Photoinitiatoren, wie oben für die binäre Mischung gezeigt. Die verallgemeinerten Gleichungen (3)/(4) besitzen die Form der Gleichung (13) und die verallgemeinerten Gleichungen (5)/(6) besitzen die Form der Gleichung (14): 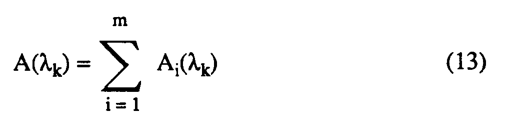
und

Aᵢ(λₖ) = εᵢ(λₖ) cᵢd (14).

Dabei bedeutet i die Laufzahl des i-ten Photoinitiators (es liegen m Photoinitiatoren vor) und k ist die Laufzahl der unterschiedlichen Wellenlängen, für die die Mischung der Photoinitiatoren abgestimmt werden soll. Die Auflösung nach den cᵢ erfolgt nach bekannten Methoden zur Lösung linearer Gleichungssysteme. Es werden im allgemeinen Fall m verschiedene Photoinitiatoren oder absorbierende Bestandteile benötigt.

Die obige Ableitung lässt sich auch für den allgemeineren Fall durchführen, worin die optische Dichte der Zusammensetzung bei λ₁ und/oder bei λ₂ neben den beiden Photoinitiatoren noch von weiteren Bestandteilen, beispielsweise den polymerisierbaren Monomeren, beeinflusst wird. Gleichungen (7) und (8) sind dann lediglich durch ein von der Initiatorkonzentration unabhängiges Korrekturglied zu erweitern, welches die optische Dichte dieser weiteren Bestandteile berücksichtigt.

Die obige Ableitung umfasst auch den Fall, worin bei λ₁ nur einer der beiden Photoinitiatoren und bei λ₂ nur der andere der beiden Photoinitiatoren absorbiert. Die obigen Gleichungen (3) und (4) vereinfachen sich stark. Die Anpassung der daraus folgenden Gleichungen an diesen Fall ist dem Fachmann an sich bekannt.

Es sei darauf hingewiesen, dass sich die optische Dichte bei den Wellenlängen λ₁ und λ₂ (λ₁ sei hier kürzerwellig als λ₂) nicht durch jede Kombination zweier Photoinitiatoren angleichen lässt. So ist diese beispielsweise nicht möglich, wenn der erste Photoinitiator bei λ₁ einen grösseren Extinktionskoeffizienten aufweist als bei λ₂ und der zweite Photoinitiator auch bei λ₁ einen grösseren Extinktionskoeffizienten aufweist als bei λ₂. Die Angleichung der optischen Dichten bei verschiedenen Wellenlängen ist immer dann möglich, wenn die obigen Formeln Lösungen haben, die für alle Konzentrationen der Photoinitiatoren cᵢ Werte grösser gleich Null haben.

Als photopolymerisierbare Verbindung lassen sich praktisch alle zur Photohärtung geeigneten Verbindungen einsetzen. Man kann auch Gemische solcher Verbindungen verwenden. Der Begriff "photopolymerisierbare Verbindung" umfasst solche Verbindungen, die sich allein oder in Kombination mit einem Photoinitiator photopolymerisieren lassen. Im Rahmen dieser Erfindung lassen sich beide Typen von Verbindungen in Kombination mit Photoinitiatoren einsetzen. Der Begriff "photopolymerisierbare Verbindung" umfasst ganz allgemein monomere, oligomere und auch polymere Verbindungen, soweit diese photopolymerisierbar sind.

Beispiele für photopolymerisierbare Verbindungen sind organische Verbindungen, die kationisch polymerisierbare und/oder radikalisch polymerisierbare Gruppen enthalten.

Bevorzugt werden radikalisch polymerisierbare Verbindungen, insbesondere Verbindungen mit durchschnittlich mehr als einer Vinylgruppe, insbesondere mit durchschnittlich mehr als einer Acrylatgruppe und/oder Methacrylatgruppe.

Besonders bevorzugt sind radikalisch polymerisierbare Verbindungen, die zwei bis fünf Acrylatester- und/oder Methacrylatestergruppen enthalten.

Die photopolymerisierbaren Verbindungen können fest oder flüssig sein. Flüssige Verbindungen oder deren Gemische sind bevorzugt.

Im erfindungsgemässen Verfahren verwendet man Photoinitiatorgemische. Als Photoinitiatoren können die für die jeweiligen photopolymerisierbaren Verbindungen an sich üblichen Verbindungen eingesetzt werden. Die Komponenten der Photoinitiatorgemische werden so ausgewählt, dass ihr Absorptionsspektrum mit mindestens einer der betreffenden Spektrallinien der Strahlungsquelle überlappt, welche die Photopolymerisation bewirken sollen.

Für kationisch polymerisierbare Monomere eignen sich beispielsweise Oniumverbindungen oder Metallocensalze, wie in der EP-A-153,904 beispielhaft aufgezählt.

Für radikalisch polymerisierbare Monomere eignen sich beispielsweise Chinone, Acetophenone, Propiophenone, Benzophenone, Xanthone, Thioxanthone, Acylnaphthaline, Acylcoumarine, Ketocoumarine, Aroylmethylenthiazoline, Hexarylimidazol-Dimere, bevorzugt in Kombination mit reduzierbaren Farbstoffen, Acyl- oder Thioacylphosphine, Titanocene, α-Dicarbonylverbindungen, O-Alkoxycarbonyloxime, O-Aroyloxime oder Benzoyldioxolane.

Beispiele für Chinone sind Benzochinon, Anthrachinone oder Tetracenchinone.

Beispiele für Acetophenone sind Acetophenon; phenylsubstituierte Acetophenone, wie 4-Cyanoacetophenon; α-halogenierte Acetophenone, wie α,α,α-Trichloracetophenon; α-alkoxysubstituierte Acetophenone, wie α,α-Diethoxyacetophenon; Benzoinether, wie α,α-Diethoxy-phenylacetophenon; α-hydroxysubstituierte Acetophenone, wie α,α-Diemthyl-α-hydroxyacetophenon oder α-Hydroxycyclohexylphenylketon; oder α-benzoylsubstituierte Acetophenone, wie Ethyl-α,α-diethoxy-α-benzoylacetat.

Beispiele für Propiophenone sind Propiophenon oder α-substituierte Derivate, wie sie oben für die entsprechenden Acetophenonderivate definiert wurden.

Beispiele für Benzophenone sind Benzophenon oder substituierte Benzophenone, wie 4-Methoxybenzophenon oder 4,4′-Bis-(N,N-dimethylamino)-benzophenon.

Beispiele für Xanthone sind Xanthon oder substituierte Xanthone, wie 2-Chlorxanthon.

Beispiele für Thioxanthone sind Thioxanthon oder substituierte Thioxanthone, wie 2-Chlorthioxanthon, 2-Isopropylthioxanthon, 1-Ethoxycarbonyl-3-(1-methyl-1-morpholinoethyl)-thioxanthon, 2-Methyl-6-dimethoxymethylthioxanthon, 2-Methyl-6-(1,1-dimethoxybenzyl)-thioxanthon, 2-Morpholinomethylthioxanthon oder 2-Methyl-6-morpholinomethylthioxanthon.

Beispiele für Acylnaphthaline sind 2-Acetylnaphthalin oder 2-Naphthaldehyd.

Beispiele für Acylcoumarine sind 3-acylsubstituierte Coumarine, wie 3-Benzoylcoumarin oder 3-Benzoyl-5-(N,N-dimethylamino)-coumarin. Weitere Beispiele für geeignete 3-Acylcoumarine finden sich in der US-P-4 419 434.

Beispiele für Aroylmethylenthiazoline sind 2-(Aroylmethylen)-thiazoline, wie 3-Methyl-2-benzoylmethylen-β-naphthothiazolin.

Ein Beispiel für ein Hexarylimidazol-Dimeres ist 2,2′-Bis-[2-chlorphenyl]-4,4′5,5′-tetraphenyl-bis-imidazol.

Ein Beispiel für ein Acylphosphin ist das 2,4,6-Trimethylbenzoyl-diphenylphosphinoxid.

Ein Beispiel für ein geeignetes Thioacylphosphin ist das, 2,4,6-Trimethylbenzoylthiodiphenylphosphinoxid.

Ein Beispiel für einen geeigneten Titanoceninitiator ist Bis-(methylcyclopentadienyl)-Ti-IV-bis-(σ-pentafluorphenyl). Weitere Beispiele für geeignete Titanoceninitiatoren findet man in den EP-A-122,223, -186,626, -255,486 und -256,986.

Ein Beispiel für eine α-Dicarbonylverbindung ist Phenylglyoxylsäure.

Beispiele für O-Alkoxycarbonyloxime oder O-Aroyloxime sind 1-Phenyl-1,2-propandion-2-(O-ethoxycarbonyl)-oxim oder 1-Phenyl-1,2-propandion-2-(O-benzoyl)-oxim.

Beispiele für Benzoyldioxolane sind 2-Benzoyl-2-phenyl-1,3-dioxolan, 2-Trichlormethyl-4-benzoyl-4-phenyl-1,3-dioxolan und 2-(p-Dimethylaminophenyl)-4-benzoyl-4-phenyl-1,3-dioxolan.

Weitere Beispiele für Photoinitiatoren sind
(a) anionischer Farbstoff-Iodoniumion-Verbindungen

   [R₁₂-I⁺-R₁₃]ₘ D^{m-},

   wobei D⁻ ein anionischer Farbstoff und m = 1 oder 2 ist, und R₁₂ und R₁₃ unabhängig voneinander ausgewählt werden aus der Gruppe bestehend aus einer aromatischen Verbindung wie beispielsweise Phenyl oder Naphthyl,
(b) anionischer Farbstoff-Pyrrylium-Verbindungen 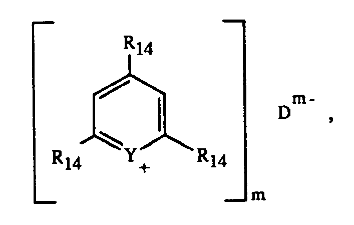 wobei D⁻ ein anionischer Farbstoff, m = 1 oder 2, R₁₄ Phenyl und Y -O- oder -S- ist. Diese Photoinitiatoren sind in US-P-4 772 530 in Spalte 11 bis 13 beschrieben und sind Gegenstand der vorliegenden Beschreibung. Beispiele für anionische Farbstoffe sind Farbstoffe, die Xanthene oder Oxonole enthalten. Geeignet sind zum Beispiel Bengal-Rosa-, Eosin-, Erythiosin- und Fluorescein-Farbstoffe.
(c) Kationischer Farbstoff-Boratanion-Komplexe 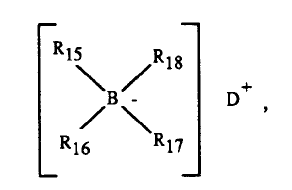 wobei D⁺ ein kationischer Farbstoff ist und R₁₅, R₁₆, R₁₇ und R₁₈ unabhängig voneinander ausgewählt werden aus der Gruppe bestehend aus Alkyl, Aryl, Alkaryl, Aralkyl, Alkenyl, Alkinyl, alicyclische und gesättigte oder ungesättigte heterocyclische Gruppen. Photoinitiatoren dieses Typs sind aus US-P-3 567 453, -4 307 182, -4 343 891, -4 447 521, -4 450 227 und insbesondere aus -4 772 530, Spalte 5 bis 10 bekannt, die ebenfalls Gegestand der vorliegenden Beschreibung sind. Beispiele für geeignete kationische Farbstoffe sind Methylenblau, Safranin O, Malachitgrün, Cyanin- oder Rhodaninfarbstoffe. Die Definitionen der Gruppen R₁₅, R₁₆, R₁₇ und R₁₈ sind in US-P-4 772 530, Spalte 6 im Detail diskutiert.
(d) Zusammensetzungen enthaltend einen photoreduzierbaren Farbstoff, ein Thiol und gegebenenfalls ein N,N-Dialkylanilin. Photoinitiatoren dieses Typs sind in US-P-4 874 685, Spalte 2 bis 4 beschrieben, die ebenfalls Gegenstand der vorliegenden Beschreibung sind. Photoreduzierbare Farbstoffe sind allgemein bekannt und enthalten photoreduzierbare Methin-, Polymethin-, Triarylmethan-, Indolin-, Thiazin-, Acridin-, Xanthan- und Oxazin-Farbstoffe. Geeignete Thiole der vorliegenden Erfindung werden durch die allgemeine Formel 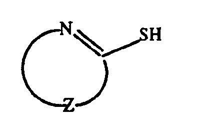 wiedergegeben, wobei Z die zur Komplettierung eines 4-10-gliedrigen mono- oder bicyclischen Ringes benötigten Atome darstellt. Beispiele hierfür sind Benzoxazole, Benzimidazole, Benzthiazole, Tetrazole etc. Obwohl Farbstoffe und Thiole allein als Photoinitiator-System verwendet werden können, werden bevorzugt N,N-Dialkylaniline als Antioxydationsmittel zugegeben. Diese Antioxydationsmittel sind beispielsweise in US 4 874 685, Spalte 3 und 4 beschrieben.

Weitere Beispiele für Photoinitiatoren der radikalischen Polymerisation sind in der DE-A-3,006,960 zu finden. Die dort aufgezählten Photoinitiatoren sind Gegenstand der vorliegenden Beschreibung.

Bevorzugt verwendet man zwei bei verschiedenen Emissionslinien der UV/VIS-Lichtquelle wirksame Photoinitiatoren.

Besonders bevorzugt verwendet man Gemische zweier Photoinitiatoren, worin das langwelligste Absorptionsmaximum eines der Photoinitiatoren zwischen 350 und 400 nm liegt und worin das langwelligste Absorptionsmaximum des zweiten Photoinitiators kurzwelliger liegt als das besagte Absorptionsmaximum des ersten Photoinitiators.

Die Gesamtmenge der Photoinitiatoren im erfindungsgemässen Verfahren beträgt im allgemeinen etwa 0,1 bis 10 Gew.%, bezogen auf die photopolymerisierbare Verbindung bzw. das Gemisch an photopolymerisierbaren Verbindungen. Durch die Vorgabe der Menge an Photoinitiator können die Eindringtiefe und die Geschwindigkeit der Photopolymerisation kontrolliert werden. Für Anwendungen, worin die Polymerisation mittels eines beweglichen Laserstrahls durchgeführt wird, sollte die Konzentration der Photoinitiatoren so gewählt werden, dass bei den technisch realisierbaren Schreibgeschwindigkeiten des gesteuerten Laserstrahls eine photopolymerisierte Schicht von etwa 0,1 bis 2,5 mm Dicke erzeugt werden kann. Das Verhältnis der Konzentrationen der Photoinitiatoren für ein bestimmtes Polymersystem wird anhand der oben gegebenen Kriterien bestimmt.

Die im erfindungsgemässen Verfahren eingesetzten Zusammensetzungen können gegebenenfalls noch weitere Zusätze enthalten, welche die Härtung nicht verhindern. Beispiele dafür sind Antioxidantien, Lichtschutzmittel, Polymerisationsinhibitoren, Entgasungsmittel, Entlüfter, Weichmacher, Streck-, Füll, und Verstärkungsmittel, Thixotropiemittel, Netz- und Verlaufmittel, Flammschutzmittel, Sensibilisatoren, Sauerstoffänger, Antisedimentationsmittel, Farbstoffe oder Pigmente. Die Gesamtmenge solcher Zusätze beträgt üblicherweise 0 bis 50 Gew.%, bezogen auf die gesamte Zusammensetzung. Eine mögliche optische Absorption solcher Zusätze bei den verwendeten Wellenlängen muss bei der Berechnung der Gesamtabsorption nach Gln. (13) und (14) berücksichtigt werden.

Die im erfindungsgemässen Verfahren eingesetzten Zusammensetzungen können in an sich bekannter Weise hergestellt werden, beispielsweise durch Vermischen der einzelnen Komponenten in den dafür üblichen Einrichtungen, wie Mischern.

Die Strahlungsenergie wird bei der Photopolymerisation der erfindungsgemäss modifizierten Zusammensetzungen optimal ausgenutzt, wodurch die Härtung auch dicker Schichten (= Schichten, bei deren Durchgang Licht der Intensität I₀ eine merkliche Abschwächung erfährt) möglich wird. Solche Zusammensetzungen eignen sich besonders zum Aufbau von 3D Objekten, insbesondere von 3D Objekten mit schichtförmigem Aufbau.

Die Erfindung betrifft daher insbesondere ein Verfahren zur Herstellung von 3D Objekten ausgehend von einer photopolymerisierbaren Zusammensetzung, deren Festigkeitseigenschaften nicht zum Aufbau von dreidimensionalen Objekten ausreichen und die durch Bestrahlung geändert werden können, so dass eine zum Aufbau von dreidimensionalen Objekten ausreichende Festigkeit erhalten wird, umfassend die Schritte:
i) Vorgabe der photopolymerisierbaren Zusammensetzung als Medium in einem Behälter, die durch Einstrahlung von Emissionslinien unterschiedlicher Wellenlänge einer UV/VIS-Laserlichtquelle photopolymerisiert werden kann, die eine photopolymerisierbare Verbindung und mindestens zwei Photoinitiatoren enthält, wobei das Verhältnis der Konzentrationen der Photoinitiatoren so ausgewählt wird, dass die photopolymerisierbare Zusammensetzung für Strahlung der verschiedenen Emissionslinien, welche die Photopolymerisation bewirken, praktisch die gleiche optische Dichte aufweist,
ii) gleichzeitige Bestrahlung eines vorbestimmten Volumenanteils besagten Mediums mit verschiedenen Emissionslinien einer UV/VIS-Laserlichtquelle, so dass sich in den bestrahlten Bereichen ein vorbestimmter Anteil des Mediums verfestigt.

In einer besonderes bevorzugten Ausführungsform dieses Verfahrens werden dünne und aufeinanderfolgende Schichten einer photopolymerisierbaren Zusammensetzung in fortlaufender Weise erzeugt. Diese Technik ist beispielsweise in Journal of Applied Photographic Engineering **8**(**4**), 185 (1982), in Rev. Sci, Instrum. **52**(**11**), 1770 (1981) und in der US-P-4,575,330 beschrieben. Die Beschreibungen dieser Publikationen sind ebenfalls Inhalt der vorliegenden Beschreibung.

Die Erfindung betrifft daher insbesondere ein Verfahren zur Herstellung von 3D Objekten ausgehend von einer photopolymerisierbaren Zusammensetzung, deren Festigkeitseigenschaften nicht zum Aufbau von dreidimensionalen Objekten ausreichen und die durch Bestrahlung geändert werden können, so dass eine zum Aufbau von dreidimensionalen Objekten ausreichende Festigkeit erhalten wird umfassend die Schritte:
i) Vorgabe der photopolymerisierbaren Zusammensetzung, wie oben definiert, als Medium in einem Behälter,
ii) gleichzeitige Bestrahlung einer ausgewählten Oberfläche besagten Mediums ganzflächig oder in einem vorgegebenen Muster mit verschiedenen Emissionslinien einer UV/VIS-Laserlichtquelle, so dass sich in den betrahlten Bereichen eine Schicht in einer gewünschten Schichtdicke verfestigt,
iii) Ausbilden einer neuen Schicht des photopolymerisierbaren Mediums auf der verfestigten Schicht, und
iv) wiederholtes Bestrahlen der Oberfläche gemäss Schritt ii), um eine Folge von aneinander haftenden, verfestigten Schichten aufzubauen, die zusammen das dreidimensionale Objekt bilden.

Für den Aufbau von 3D Objekten werden im allgemeinen flüssige, photopolymerisierbare Zusammensetzungen eingesetzt. Geeignete Harzgemische müssen darüber hinaus noch zusätzliche Spezifikationen erfüllen. Beispiele dafür sind:
A) Die Viskosität muss an die Apparatur zur Herstellung der 3D Objekte angepasst sein. Bei den derzeitig gängigen Verfahren sollte die Viskosität sich im Bereich von 500 bis 8'000 mPa s, insbesondere im Bereich von 1'000 bis 4'000 (bei 25 °C) bewegen.
B) Eine für die Herstellung von 3D Objekten geeignete Harzzusammensetzung sollte eine möglichst grosse Eindringtiefe aufweisen und mit einer möglichst kleinen Strahlungsenergie gehärtet werden können. Der dafür gängige Parameter ist als "Verarbeitungsgeschwindigkeit" bekannt und beschreibt den Zusammenhang zwischen auftreffender Strahlungsenergie und Eindringtiefe.
C) Bei der Herstellung der 3D Objekte werden aufeinanderfolgende dünne Schichten nacheinander photopolymerisiert. Dabei wird in der Regel keine dieser Schichten voll ausgehärtet. Dies hat einige Vorteile zur Folge, wie beispielsweise eine verminderte Schrumpfung bei der Polymerisation (und somit verringerte innere Spannungen oder Deformationen), verringerte Aufbauzeit und manchmal eine verbesserte chemische Reaktivität der einzelnen Schichten, so dass diese besser aneinander haften. Die Zugscherfestigkeit eines solchen teilweise gehärteten 3D Objekts (eines sogenannten "green part") ist als "green strength" bekannt. Die "green strength" eines "green part" ist eine wichtige Kenngrösse, da nach dem Aufbau aller Schichten das Objekt aus dem flüssigen Photopolymer herausgehoben wird. Objekte mit einer niedrigen "green strength" können zum Beispiel aufgrund ihres eigenen Gewichts deformiert oder zerstört werden. Ein "green part" muss in der Regel noch nachgehärtet werden.
D) Eine weitere wichtige Kenngrösse ist die Schrumpfung und die Deformation aufgrund von inneren Spannungen, die ein 3D Objekt infolge der Polymerisation erfährt.
E) Ferner werden an das fertiggestellte 3D Objekt gewisse Anforderungen gestellt, beispielsweise gute mechanische Eigenschaften, wie Zugfestigkeit, Schlagzähigkeit oder Bruchdehnung.

Aus dieser Aufzählung wird deutlich, dass die Auswahl einer geeigneten flüssigen Harzzusammensetzung ein kritischer Faktor bei der Herstellung von 3D Objekten ist. In den letzten Jahren sind einige Anstrengungen zur Herstellung von Harzzusammensetzungen unternommen worden, die sich für die Herstellung von 3D Objekten eignen.

Beispiele dafür sind das in Rev. Sci, Instrum., **52**(**11**), 1770 (1981) erwähnte Produkt "Tevista". Dabei handelt es sich um ein Gemisch aus ungesättigtem Polyester, Acrylester, Stryrolmonomeren, Photoinitiator und Sensibilisator.

Weitere für die Herstellung von 3d Objekten geeignete Monomere und Harzzusammensetzungen sind in der US-P-4 100 141 und in der WO-A-89/08021 offenbart, deren Inhalt auch Gegenstand der vorliegenden Beschreibung ist.

Gängige kommerziell erhältliche Harzsysteme für die Herstellung von 3D Objekten sind die Produkte "Desolite® SLR 800" und "Desolite® SLR 801" von der Fa. De Soto Inc oder Cibatool® SL XB 5081 der Fa. Ciba-Geigy. Dabei handelt es sich um Gemische verschiedener Vinylmonomere mit einem Photoinitiator.

Bevorzugte für die Herstellung von 3D Objekten geeignete photopolymerisierbare Zusammensetzungen weisen eine Viskosität von 500 bis 8'000 mPa s (bei 25 °C), insbesondere von 1'000 bis 4'000 mPa s auf und besitzen einen Volumenschwund beim Uebergang vom flüssigen in den auspolymerisierten Zustand von weniger als 8 Vol.%, bezogen auf die flüssige Zusammensetzung.

Besonders bevorzugt sind photopolymerisierbare Zusammensetzungen, die im Bereich von 250 bis 450 nm polymerisiert werden können und die eine Strahlungsempfindlichkeit von weniger als 200 mJ/cm² aufweisen.

Ebenfalls besonders bevorzugt sind photopolymerisierbare Zusammensetzungen, die im Bereich von 450 bis 800 nm polymerisiert werden können und die eine Strahlungsempfindlichkeit von weniger als 2 J/cm² aufweisen.

Die obigen Werte beziehen sich dabei auf diejenige Strahlungsempfindlichkeit, mit der eine Schicht mit einem E-Modul von mindestens 10 N/mm² erzeugt werden kann.

Bevorzugte photopolymerisierbare Zusammensetzungen enthalten di-, tri-, tetra- oder pentafunktionelle monomere oder oligomere Acrylat- oder Methacrylatester, und weisen eine Viskosität von 500 bis 8′000 mPa s (bei 25 °C), insbesondere von 1′000 bis 4′000 mPa s, auf.

Ganz besonders bevorzugte photopolymerisierbare Zusammensetzungen enthalten als photopolymerisierbare Monomere
a) wenigstens ein difunktionelles monomeres oder oligomeres Acrylat oder Methacrylat mit einer Viskosität von mehr als 500 mPa s (bei 25 °C),
b) wenigstens eine Verbindung der Formel I, II oder III

   R₁―CH₂―C(̵CH₂―R₂)_{₃} (I),

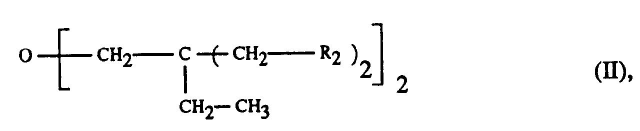

   R₂―CH(̵CH₂―R₂)_{₂} (III),

   worin R₁ Wasserstoff, Methyl, Hydroxyl oder einen Rest der Formel IV bedeutet 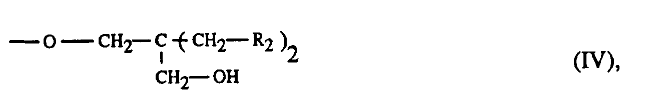 und R₂ eine Gruppe der Formel V ist 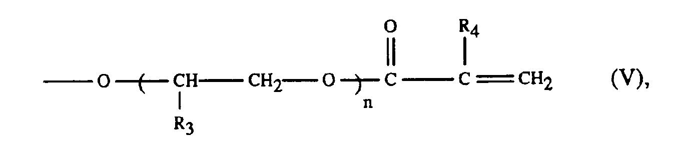 worin n 0, 1, 2 oder 3 bedeutet, und R₃ und R₄ unabhängig voneinander Wasserstoff oder Methyl sind, und
c) wenigstens eine Verbindung der Formel VI 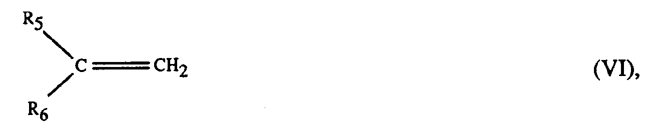 worin R₅ Wasserstoff oder Methyl ist und R₆ eine Gruppe der Formel VII bedeutet 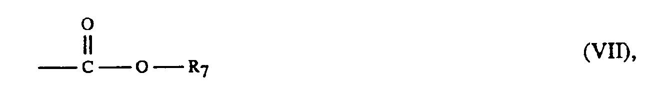 worin R₇ ausgewählt wird aus der Gruppe bestehend aus Tetrahydrofurfuryl, Cyclohexyl, 2-Phenoxyethyl, Benzyl, Isobornyl, Glycidyl, Dicyclopentenyl, Morpholinoethyl, Dimethylaminoethyl, Diethylaminoethyl oder einem C₁-C₂₀ Alkylrest, der linear oder verzweigt sein kann, oder, falls R₅ Wasserstoff bedeutet, R₆ auch Pyrrolidinon-2-yl, Imidazolyl, Carbazolyl, Anthracenyl, Phenyl, C₅-C₈ Cycloalkyl, Naphthenyl, 2-Norbornyl, Pyridyl, N-Caprolactamyl oder Tolyl sein kann.

Die Zusammensetzungen enthaltend Komponenten a), b) und c) zeichnen sich durch eine hohe "green strength" und durch eine niedrige Schrumpfung und Deformation bei der Polymerisation aus. Die fertigen 3D Objekte besitzen gute mechanische Eigenschaften. Ferner kann die "Verarbeitungsgeschwindigkeit" infolge der Anpassung des Photoinitiatorsystems gesteigert werden.

In einer besonders bevorzugten Ausführungsform wird als Komponente a) eine Verbindung der Formel VIII eingesetzt 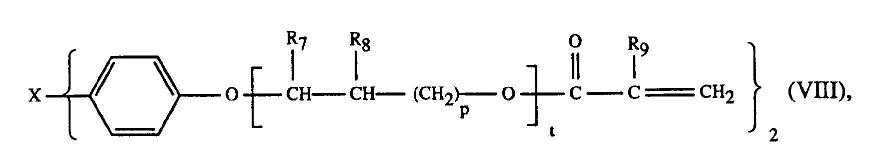
worin p 0 oder 1 ist, t 0 oder 1 bedeutet und für den Fall, dass p 0 ist, t auch 2 oder 3 bedeuten kann, X -O-, -S-, -SO₂- oder -C(R₁₀)(R₁₁)- ist, R₁₀ und R₁₁ unabhängig voneinander Wasserstoff, Trifluormethyl oder Methyl bedeuten, R₇ Wasserstoff ist und, für den Fall, dass p 0 ist, auch Methyl bedeuten kann, R₈ im Falle von p = 0 Wasserstoff ist und im Falle von p = 1 Hydroxyl bedeutet, und R₉ Wasserstoff oder Methyl ist.

Verbindungen der Formel VIII, worin p = 1 ist, sind beispielsweise aus der US-P-3 661 576 bekannt. Diese Verbindungen sind erhältlich durch Umsetzung der entsprechenden Diglycidylether mit Acryl- oder Methacrylsäure. Man erhält im allgemeinen Gemische von oligomeren Materialien. Die Viskosität dieser Gemische lässt sich durch Zugabe der Komponenten b) und c) einstellen.

Verbindungen der Formel VIII, worin p = 0 ist, sind beispielsweise aus der GB-A-1,263,541 bekannt. Diese Verbindungen sind erhältlich durch Umesterung der entsprechenden Diole mit Estern der Acryl- oder der Methacrylsäure.

Der Anteil an Komponente a), bezogen auf die Menge an Komponenten a), b) und c), beträgt im allgemeinen etwa 10 bis 80 Gew.%, insbesondere etwa 25 bis 80 Gew.%.

R₁ ist vorzugsweise Methyl oder ein Rest der Formel IV; R₂ ist vorzugsweise ein Rest der Formel V; und n ist vorzugsweise 0.

Besonders bevorzugte Komponenten b) sind Trimethylolpropantrimethacrylat und Dipentaerythritol-pentaacrylat. Neben diesen Monomeren ist dem Fachmann eine grosse Anzahl tri- oder multifunktioneller Acrylate oder Methacrylate bekannt. Beispiele dafür sind Pentaerythritol-tetraacrylat, Glycerintriacrylat oder das Triacrylat des Tris-(hydroxyethyl)-isocyanurats. Viele dieser Acrylate sind kommerziell erhältlich.

Der Anteil an Komponente b), bezogen auf die Menge an Komponenten a), b) und c), beträgt zweckmässig etwa 5 bis 25 Gew.%.

Die Verbindungen der Formel VI sind ebenfalls an sich bekannt und sind teilweise kommerziell erhältlich. Viele Verbindungen dieses Typs besitzen eine niedrige Viskosität, weshalb sie sich zum Einstellen eines gewünschten Viskositätswertes des Gemisches aus Komponenten a), b) und c) eignen.

Beispiele für solche Verbindungen sind 1-Vinylpyrrolidon, Isobornylacrylat oder Phenoxyethylacrylat.

Besonders bevorzugt verwendet man Verbindungen der Formel VI mit einem Siedepunkt oberhalb von 140 °C.

Der Anteil an Komponente c), bezogen auf die Menge an Komponenten a), b) und c), beträgt in der Regel etwa 1 bis 25 Gew.%, insbesondere etwa 5 bis 25 Gew.%.

Für die Photopolymerisation lassen sich alle an sich bekannten UV/VIS-Laserlichtquellen verwenden, die gleichzeitig mehrere Emissionslinien emittieren. Der Begriff "UV/VIS" bezeichnet elektromagnetische Strahlungen im Wellenlängenbereich von etwa 200 bis etwa 800 nm. Der Begriff "UV/VIS-Laserlichtquelle" bezeichnet Laserlichtquellen, die mehrere Linien im UV-Bereich oder im sichtbaren Bereich oder im UV-Bereich und im sichtbaren Bereich emittieren, eventuell mit Frequenzverdopplung.

Besonders bevorzugt sind Laser, die ausgewählt sind aus der Gruppe bestehend aus Ar-Ionenlasern mit Mehrlinienbetrieb im UV-Bereich und/oder im sichtbaren Bereich und Kupferdampf-Lasern.

Zur Herstellung von 3D Objekten eignen sich insbesondere Laserlichtquellen, deren Strahlung über die Oberfläche der photopolymerisierbaren Zusammensetzung mit Hilfe eines Computers gesteuert wird.

Der erfindungsgemässen Zusammensetzungen eignen sich hervorragend zur Herstellung von photopolymerisierten Schichten, insbesondere in Form von 3D Objekten, die aus einer Folge von aneinander haftenden, verfestigten Schichten aufgebaut sind. Diese Verwendung ist ebenfalls ein Gegenstand der vorliegenden Erfindung.

Die folgenden Beispiele erläutern die Erfindung. Dabei bedeuten Teile Gewichtsteile:

### Beispiel 1:

Eine Harzformulierung bestehend aus
49 Teilen eines Adduktes von Acrylsäure an einen Diglycidylether auf Basis von Bisphenol A (Novacure® 3700),
5 Teilen 2-Phenoxyethylacrylat (Sartomer® 339),
12 Teilen Trimethylolpropantriacrylat (Sartomer® 351),
25 Teilen des Diesters von Acrylsäure mit ethoxyliertem Bisphenol A (Sartomer® 349) und
5 Teilen N-Vinyl-2-pyrrolidon
wird mit
1,15 Teilen 2,4,6-Trimethylbenzoyldiphenylphosphinoxid (Lucirin® TPO) und
2,06 Teilen 1-Hydroxycyclohexylphenylketon
vermischt.

Die Formulierung hat bei den Ar-Laser-Wellenlängen von 351 und 364 nm die gleiche Absorption (optische Dichte von 2,0 für eine Schichtdicke von 1 mm) sowie eine gute Empfindlichkeit als Harz für den Aufbau von 3D Objekten (0,5 mm Polymerisationstiefe bei 18 mJ/cm² UV-Bestrahlung bei den obigen Wellenlängen).

### Beispiel 2: Herstellung eines 3D Objektes

Mit der Harzformulierung gemäss Beispiel 1 wird auf einer StereoLithographie Apparatur (SLA-1 von 3D Systems Inc., Valencia/USA) ein Schulterstab (Zugprüfkörper) nach DIN 53455 mit folgenden Bauparametern hergestellt:
Verwendung eines UV-Argonlasers von 6 mW Ausgangsleistung (nach der Ablenkoptik gemessen) anstelle des eingebauten Lasers;
Schreibgeschwindigkeit: 7,15 cm/sec;
Schichtdicke: 0,4 mm;
Schichtabstand: 0,25 mm;
interne Fachwerkstruktur ("cross hatch") mit 0°, 60° und 120° Drehung gegenüber den Längsseiten.

Diese Prüfkörper haben nach der vollständigen Aushärtung unter einer Quecksilberdampflampe einen Elastizitätsmodul von 3600 N/mm² und eine Bruchdenung von 2,5 %.

### Beispiel 3:

Eine Harzformulierung besthend aus
49 Teilen eines Adduktes von Acrylsäure an einen Diglycidylether auf Basis von Bisphenol A (Novacure® 3700),
5 Teilen 2-Phenoxyethylacrylat (Sartomer® 339),
12 Teilen Trimethylolpropantrimethacrylat (Sartomer® 350),
25 Teilen des Diesters von Methacrylsäure mit ethoxyliertem Bisphenol A (Sartomer® 348) und
5 Teilen N-Vinyl-2-pyrrolidon
wird mit
1,15 Teilen 2,4,6-Trimethylbenzoyldiphenylphosphinoxid (Lucirin® TPO) und
2,06 Teilen 1-Hydroxycyclohexylphenylketon
vermischt.

Die Formulierung hat bei den Ar-Laser-Wellenlängen von 351 und 364 nm die gleiche Absorption (optische Dichte von 2,0 für eine Schichtdicke von 1 mm) sowie eine gute Empfindlichkeit als Harz für den Aufbau von 3D Objekten (0,5 mm Polymerisationstiefe bei 22 mJ/cm² UV-Bestrahlung bei den obigen Wellenlängen).

### Beispiel 4:

Eine Harzformulierung bestehend aus
49 Teilen eines Adduktes von Acrylsäure an einen Diglycidylether auf Basis von Bisphenol A (Novacure® 3700),
5 Teilen 2-Phenoxyethylacrylat (Sartomer® 339),
12 Teilen Trimethylolpropantriacrylat (Sartomer® 351),
25 Teilen des Diesters von Acrylsäure mit ethoxylierem Bisphenol A (Sartomer® 349) und
5 Teilen N-Vinyl-2-pyrrolidon
wird mit
1,18 Teilen 2,4,6-Trimethylbenzoyldiphenylphosphinoxid (Lucirin® TPO) und
0,7 Teile α,α-Dimethyl-α-N-morpholino-4-methylthioacetophenon vermischt.

Die Formulierung hat bei den Ar-Laser-Wellenlängen von 351 und 364 nm die gleiche Absorption (optische Dichte von 2,0 für eine Schichtdicke von 1 mm).

### Beispiel 5:

Eine Harzformulierung besthend aus
49 Teilen eines Adduktes von Acrylsäure an einen Diglycidylether auf Basis von Bisphenol A (Novacure® 3700),
5 Teilen 2-Phenoxyethylacrylat (Sartomer® 339),
12 Teilen Trimethylolpropantrimethacrylat (Sartomer® 350),
25 Teilen des Diesters von Methacrylsäure mit ethoxyliertem Bisphenol A (Sartomer® 348) und
5 Teilen N-Vinyl-2-pyrrolidon
wird mit
1,50 Teilen 2,4,6-Trimethylbenzoyldiphenylphosphinoxid (Lucirin® TPO) und
2,68 Teilen 1-Hydroxycyclohexylphenylketon
vermischt.

Die Formulierung hat bei den Ar-Laser-Wellenlängen von 351 und 364 nm die gleiche Absorption (optische Dichte von 2,6 für eine Schichtdicke von 1 mm) sowie eine gute Empfindlichkeit als Harz für den Aufbau von 3D Objekten (0,3 mm Polymerisationstiefe bei 24 mJ/cm² UV-Bestrahlung bei den obigen Wellenlängen).

### Beispiel 6:

Eine Harzformulierung bestehend aus
49 Teilen eines Adduktes von Acrylsäure an einen Diglycidylether auf Basis von Bisphenol A (Novacure® 3700),
5 Teilen 2-Phenoxyethylacrylat (Sartomer® 339),
12 Teilen Trimethylolpropantrimethyacrylat (Sartomer® 350),
25 Teilen des Diesters von Methacrylsäure mit ethoxylierterm Bisphenol A (Sartomer® 348) und
5 Teilen N-Vinyl-2-pyrrolidon
wird mit
0,98 Teilen 2,4,6-Trimethylbenzoyldiphenylphosphinoxid (Lucirin® TPO) und
0,98 Teile α,α-Dimethyl-α-cyclohexylactophenon
vermischt.

Die Formulierung hat bei den Ar-Laser-Wellenlängen von 351 und 364 nm die gleiche Absorption (optische Dichte von 2,0 für eine Schichtdicke von 1 mm) sowie eine gute Empfindlichkeit als Harz für den Aufbau von 3D Objekten (0,5 mm Polymerisationstiefe bei 24 mJ/cm² UV-Bestrahlung bei den obigen Wellenlängen).

## Patentansprüche

1. Verfahren zur Herstellung von photopolymerisierbaren Zusammensetzungen, wobei die photopolymerisierbaren Zusammensetzungen durch Einstrahlung von Emissionslinien unterschiedlicher Wellenlänge einer UV/VIS-Laserlichtquelle photopolymerisiert werden können und eine photopolymerisierbare Verbindung und mindestens zwei Photoinitiatoren enthalten, dadurch gekennzeichnet, dass durch Abstimmung der Strahlungsempfindlichkeit das Verhältnis der Konzentrationen der einzelnen Photoinitiatoren so ausgewählt wird, dass die photopolymerisierbare Zusammensetzung für Strahlung der verschiedenen Emissionslinien, welche die Photopolymerisation bewirken, praktisch die gleiche optische Dichte aufweist.

2. Verfahren gemäss Anspruch 1, dadurch gekennzeichnet, dass die photopolymerisierbare Verbindung eine radikalisch polymerisierbare Verbindung oder ein Gemisch solcher Verbindungen ist.

3. Verfahren gemäss Anspruch 2, dadurch gekennzeichnet, dass die radikalisch polymerisierbare Verbindung zwei bis fünf Acrylatester- und/oder Methacrylatestergruppen enthält.

4. Verfahren gemäss Anspruch 1, dadurch gekennzeichnet, dass Gemische zweier Photoinitiatoren eingesetzt werden, worin das langwelligste Absorptionsmaximum eines der Photoinitiatoren zwischen 350 und 400 nm liegt und worin das langwelligste Absorptions-maximum des zweiten Photoinitiators kurzwelliger liegt als das besagte Absorptions-maximum des ersten Photoinitiators.

5. Verfahren zur Herstellung von dreidimensionalen Objekten ausgehend von einer photopolymerisierbaren Zusammensetzung gemäss Anspruch 1, deren Festigkeitseigenschaften nicht zum Aufbau von dreidimensionalen Objekten ausreichen und die durch Bestrahlung geändert werden können, so dass eine zum Aufbau von dreidimensionalen Objekten ausreichende Festigkeit erhalten wird, umfassend die Schritte:
i) Vorgabe der photopolymerisierbaren Zusammensetzung als Medium in einem Behälter, die durch Einstrahlung von Emissionslinien unterschiedlicher Wellenlänge einer UV/VIS-Laserlichtquelle photopolymerisiert werden kann, die eine photopolymerisierbare Verbindung und mindestens zwei Photoinitiatoren enthält wobei das Verhältnis der Konzentrationen der Photoinitiatoren so ausgewählt wird, dass die Zusammensetzung für Strahlung der verschiedenen Emissionslinien, welche die Photopolymerisation bewirken, praktisch die gleiche optische Dichte der zu polymerisierenden Zusammensetzung aufweist,
ii) gleichzeitige Bestrahlung eines vorbestimmten Volumenanteils besagten Mediums mit verschiedenen Emissionslinien einer UV/VIS-Laserlichtquelle, so dass sich in den bestrahlten Bereichen ein vorbestimmter Anteil des Mediums verfestigt.

6. Verfaren zur Herstellung von dreidimensionalen Objekten gemäss Anspruch 5 umfassend die Schritte:
i) Vorgabe der photopolymerisierbaren Zusammensetzung gemäss Anspruch 5 als Medium in einem Behälter,
ii) gleichzeitige Bestrahlung einer ausgewählten Oberfläche besagten Mediums ganzflächig oder in einem vorgegebenen Muster mit verschiedenen Emissionslinien einer UV/VIS-Laserlichtquelle, so dass sich in den bestrahlten Bereichen eine Schicht in einer gewünschten Schichtdicke verfestigt,
iii) Ausbilden einer neuen Schicht des photopolymerisierbaren Mediums auf der verfestigten Schicht, und
iv) wiederholtes Bestrahlen der Oberfläche gemäss Schritt ii), um eine Folge von aneinander haftenden, verfestigten Schichten aufzubauen, die zusammen das dreidimensionale Objekt bilden.

7. Verfahren gemäss Anspruch 1, dadurch gekennzeichnet, dass die photopolymerisierbare Zusammensetzung eine Viskosität von 500 bis 8′000 mPa s (bei 25 °C) aufweist und einen Volumenschwund beim Uebergang vom flüssigen in den auspolymerisierten Zustand von weniger als 8 Vol.%, bezogen auf die flüssige Zusammensetzung besitzt.

8. Verfahren gemäss Anspruch 1, dadurch gekennzeichnet, dass die photopolymerisierbare Zusammensetzung di, tri-, tetra- oder pentafunktionelle monomere oder oligomere Acrylat- oder Methacrylatester enthält und eine Viskosität von 500 bis 8′000 mPa s (bei 25 °C) aufweist.

9. Verfahren gemäss Anspruch 1, dadurch gekennzeichnet, dass die photopolymerisierbare Zusammensetzung im Bereich von 250 bis 450 nm polymerisiert werden kann und eine Strahlungsempfindlichkeit von weniger als 200 mJ/cm² aufweist oder dass die photopolymerisierbare Zusammensetzung im Bereich von 450 bis 800 nm polymerisiert werden kann und eine Strahlungsempfindlichkeit von weniger als 2 J/cm² aufweist.

10. Verfahren gemäss Anspruch 1, dadurch gekennzeichnet, dass die photopolymerisierbare Zusammensetzung als photopolymerisierbare Monomere enthält:
a) wenigstens ein difunktionelles monomeres oder oligomeres Acrylat oder Methacrylat mit einer Viskosität von mehr als 500 mPa s (bei 25 °C),
b) wenigstens eine Verbindung der Formel I, II oder III
R₁―CH₂―C(̵CH₂―R₂)_{₃} (I), 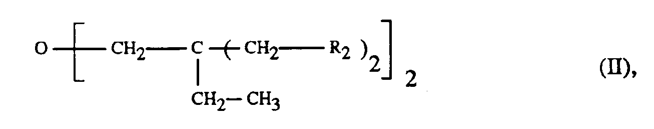
R₂―CH(̵CH₂―R₂)_{₂} (III),
worin R₁ Wasserstoff, Methyl, Hydroxyl oder einen Rest der Formel IV bedeutet 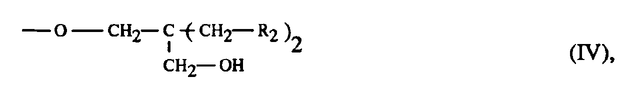 und R₂ eine Gruppe der Formel V ist 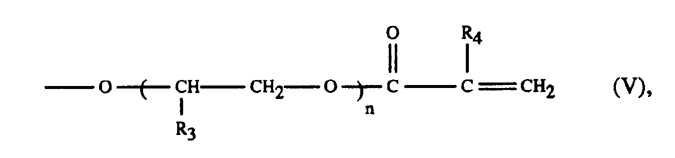 worin n 0, 1, 2 oder 3 bedeutet, und R₃ und R₄ unabhängig voneinander Wasserstoff oder Methyl sind, und
c) wenigstens eine Verbindung der Formel VI 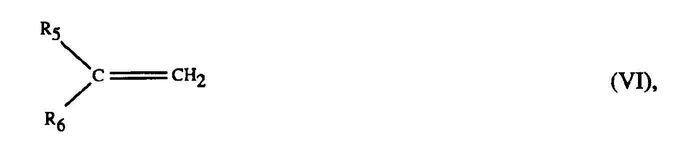 worin R₅ Wasserstoff oder Methyl ist und R₆ eine Gruppe der Formel VII bedeutet 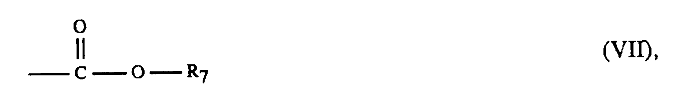 worin R₇ ausgewählt wird aus der Gruppe bestehend aus Tetrahydrofurfuryl, Cyclohexyl, 2-Phenoxyethyl, Benzyl, Isobornyl, Glycidyl, Dicyclopentenyl, Morpholinoethyl, Dimethylaminoethyl, Diethylaminoethyl oder einem C₁-C₂₀ Alkylrest, der linear oder verzweigt sein kann, oder, falls R₅ Wasserstoff bedeutet, R₆ auch Pyrrolidinon-2-yl, Imidazolyl, Carbazolyl, Anthracenyl, Phenyl, C₅-C₈ Cycloalkyl, Naphthenyl, 2-Norbornyl, Pyridyl, N-Caprolactamyl oder Tolyl sein kann.

11. Verfahren gemäss Anspruch 1, dadurch gekennzeichnet, dass die Laserlichtquelle ausgewählt wird aus der Gruppe besthend aus Ar-Ionenlasern mit Mehrlinienbetrieb im UV-Bereich und/oder im sichtbaren Bereich und Kupferdampf-Lasern.

12. Zusammensetzung gemäss Anspruch 1 zur Verwendung bei der Herstellung von photopolymerisierten Schichten, insbesondere in Form von dreidimensionalen Objekten, die aus einer Folge von aneinander haftenden, verfestigten Schichten aufgebaut sind.

## Claims

1. A process for the preparation of photopolymerizable compositions, wherein the photopolymerizable compositions can be photopolymerized by the irradiation of emission lines of differing wavelengths from a UV/VIS laser light source, and contain a photopolymerizable compound and at least two photoinitiators, which comprises selecting the ratio of the concentrations of the individual photoinitiators, by adjusting the sensitivity to radiation, in such a way that the photopolymerizable composition has virtually the same optical density for radiation of the different emission lines which effect the photopolymerization.

2. A process according to claim 1, wherein the photopolymerizable compound is a compound which can be polymerized by free radicals or a mixture of such compounds.

3. A process according to claim 2, wherein the compound which can be polymerized by free radicals contains two to five acrylate ester and/or methacrylate ester groups.

4. A process according to claim 1, wherein mixtures of two photoinitiators are used in which the absorption maximum of longest wavelength of one of the photoinitiators is between 350 and 400 nm and in which the absorption maximum of longest wavelength of the second photoinitiator is at a wavelength shorter than the said absorption maximum of the first photoinitiator.

5. A process for the production of three-dimensional objects, starting from a photopolymerizable composition according to claim 1 the strength properties of which do not suffice for the build-up of three-dimensional objects and which can be changed by irradiation so that a strength adequate for the build-up of three-dimensional objects is obtained, comprising the steps of:
i) initially using the photopolymerizable composition as a medium in a container, the composition being capable of being photopolymerized by the irradiation of emission lines of differing wavelengths from a UV/VIS laser light source, and containing a photopolymerizable compound and at least two photoinitiators, the ratio between the concentrations of the photoinitiators being so selected that the composition has virtually the same optical density as the composition to be polymerized for radiation of the different emission lines which effect the photopolymerization,
ii) irradiating at the same time a predetermined fraction of the volume of the said medium with different emission lines from a UV/VIS laser light source so that a predetermined portion of the medium solidifies in the irradiated areas.

6. A process for the production of three-dimensional objects according to claim 5, comprising the steps of:
i) initially using the photopolymerizable composition according to claim 5 as a medium in a container,
ii) irradiating at the same time a selected surface of the said medium over its whole area or in a predetermined pattern with different emission lines from a UV/VIS laser light source so that a layer solidifies in a desired layer thickness in the irradiated areas,
iii) forming a new layer of the photopolymerizable medium on the solidified layer, and
iv) repeatedly irradiating the surface in accordance with step ii) in order to build up a succession of solidified layers which adhere to one another and which together form the three-dimensional object.

7. A process according to claim 1, wherein the photopolymerizable composition has a viscosity of 500 to 8000 mPa s (at 25°C) and a volume shrinkage when passing from the liquid state into the completely polymerized state of less than 8% by volume, based on the liquid composition.

8. A process according to claim 1, wherein the photopolymerizable composition contains di-, tri-, tetra- or penta-functional monomeric or oligomeric acrylate or methacrylate esters and has a viscosity of 500 to 8000 mPa s (at 25°C).

9. A process according to claim 1, wherein the photopolymerizable composition can be polymerized within the range from 250 to 450 nm and has a sensitivity to radiation of less than 200 mJ/cm² or wherein the photopolymerizable composition can be polymerized within the range from 450 to 800 nm and has a sensitivity to radiation of less than 2J/cm².

10. A process according to claim 1, wherein the photopolymerizable composition contains, as photopolymerizable monomers:
a) at least one difunctional monomeric or oligomeric acrylate or methacrylate having a viscosity of more than 500 mPa s (at 25°C),
b) at least one compound of the formula I, II or III
R₁―CH₂―C(̵CH₂―R₂)_{₃} (I), 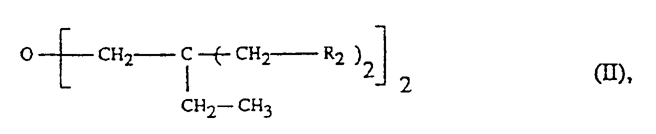
R₂―CH(̵CH₂―R₂)_{₂} (III),
in which R₁ is hydrogen, methyl, hydroxyl or a radical of the formula IV 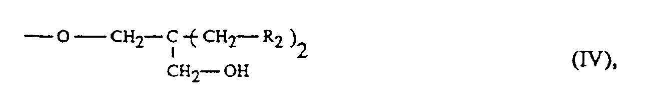 and R₂ is a group of the formula V 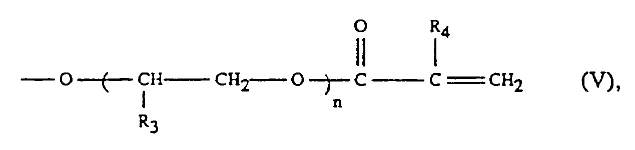 in which n is 0, 1, 2 or 3 and R₃ and R₄ are each independently of one another hydrogen or methyl, and
c) at least one compound of the formula VI 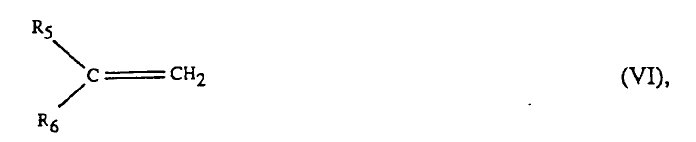 in which R₅ is hydrogen or methyl and R₆ is a group of the formula VII 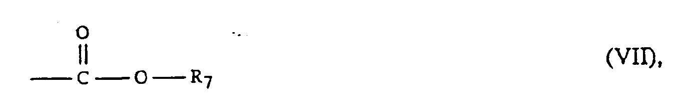 in which R₇ is selected from the group consisting of tetrahydrofurfuryl, cyclohexyl, 2-phenoxyethyl, benzyl, isobornyl, glycidyl, dicyclopentenyl, morpholinoethyl, dimethylaminoethyl, diethylaminoethyl or a C₁-C₂₀alkyl radical which can be linear or branched, or, if R₅ is hydrogen, R₆ can also be pyrrolidinon-2-yl, imidazolyl, carbazolyl, anthracenyl, phenyl, C₅-C₈cycloalkyl, naphthenyl, 2-norbornyl, pyridyl, N-caprolactamyl or tolyl.

11. A process according to claim 1, wherein the laser light source is selected from the group consisting of Ar-ion lasers having a multi-line operation within the UV range and/or within the visible range and copper vapour lasers.

12. A composition according to claim 1 for use in the production of photopolymerized layers, particularly in the form of three-dimensional objects, which are built up from a succession of solidified layers adhering to one another.

## Revendications

1. Procédé pour préparer des compositions photopolymérisables, les compositions photopolymérisables pouvant être photopolymérisées par exposition à des raies d'émission, à différentes longueurs d'onde, d'une source de lumière laser UV/VIS, et contenant un composé photopolymérisable et en général au moins deux photoamorceurs, caractérisé en ce que, pour ajuster la sensibilité au rayonnement, on choisit le rapport entre les concentrations des différents photoamorceurs de façon que la composition photopolymérisable présente pratiquement la même densité optique pour un rayonnement correspondant aux différentes raies d'émission qui provoquent la photopolymérisation.

2. Procédé selon la revendication 1, caractérisé en ce que le composé photopolymérisable est un composé polymérisable par polymérisation radicalaire ou un mélange de ces composés.

3. Procédé selon la revendication 2, caractérisé en ce que le composé polymérisable par polymérisation radicalaire contient de 2 à 5 groupes acrylate et/ou méthacrylate.

4. Procédé selon la revendication 1, caractérisé en ce qu'on utilise des mélanges de 2 photoamorceurs, où le maximum d'absorption à la longueur d'onde la plus grande d'un photoamorceur est comprise entre 350 et 400 nm, le maximum d'absorption à la longueur d'onde la plus longue du deuxième photoamorceur correspondant à une longueur d'onde plus courte que le maximum d'absorption mentionné ci-dessus du premier photoamorceur.

5. Procédé pour fabriquer des objets tridimensionnels à partir d'une composition photopolymérisable selon la revendication 1, dont les propriétés de résistance mécanique ne suffisent pas à la constitution d'objets tridimensionnels et peuvent être modifiées par une irradiation, de façon à obtenir une résistance mécanique suffisante pour la réalisation d'objets tridimensionnels, ce procédé comprenant les étapes consistant :
i) à placer sous forme fluide dans un récipient la composition photopolymérisable, qui peut être photopolymérisée par exposition à des raies d'émission ayant différentes longueurs d'onde et provenant d'une source de lumière laser UV/VIS, la composition contenant un composé photopolymérisable et au moins deux photoamorceurs, le rapport des concentrations des photoamorceurs étant choisi de façon que la composition photopolymérisable présente pratiquement la même densité optique pour des rayonnements correspondant à différentes raies d'émission, qui provoquent la photopolymérisation,
ii) à exposer simultanément une partie volumique prédéfinie du fluide ci-dessus à différentes raies d'émission d'une source de lumière laser UV/VIS, de façon que, dans les zones irradiées, une certaine partie prédéfinie du fluide se solidifie.

6. Procédé pour fabriquer des objets tridimensionnels selon la revendication 5, qui comprend les étapes consistant :
i) à placer sous forme d'un fluide dans un récipient la composition photopolymérisable telle que définie ci-dessus,
ii) à irradier en même temps une surface présélectionnée du fluide ci-dessus, sur toute la surface ou selon un dessin prédéfini, à l'aide de différentes raies d'émission d'une source de lumière de laser UV/VIS, de façon que, dans les zones irradiées, une couche se solidifie sur une épaisseur voulue,
iii) à réaliser une nouvelle couche du fluide photopolymérisable sur la couche solidifiée, et
iv) à irradier la surface selon l'étape ii), pour constituer une succession de couches solidifiées qui adhèrent les unes aux autres, et qui toutes ensemble forment l'objet tridimensionnel.

7. Procédé selon la revendication 1, caractérisé en ce que la composition photopolymérisable a, à 25°C, une viscosité de 500 à 8000 mPa.s et un retrait volumique, lors de la transition liquide à l'état polymérisé, inférieur à 8 % en volume par rapport à la composition liquide.

8. Procédé selon la revendication 1, caractérisé en ce que la composition photopolymérisable contient des acrylates ou méthacrylates monomères ou oligomères, di-, tri-, tétra- ou pentafonctionnels, et a une viscosité à 25°C de 500 à 8000 mPa.s.

9. Procédé selon la revendication 1, caractérisé en ce que la composition photopolymérisable peut être polymérisée entre 250 et 450 nm et présente une sensibilité au rayonnement inférieure à 200 mJ/cm², ou encore que la composition photopolymérisable peut être polymérisée entre 450 et 800 nm et présente une sensibilité au rayonnement inférieure à 2 J/cm².

10. Procédé selon la revendication 1, caractérisé en ce que la composition photopolymérisable contient comme monomères photopolymérisables les composés suivants :
a) au moins un acrylate ou un méthacrylate monomère ou oligomère difonctionnel ayant à 25°C une viscosité supérieure à 500 mPa.s,
b) au moins un composé de formule (I), (II) ou (III)
R₁―CH₂―C(̵CH₂―R₂)_{₃} (I), 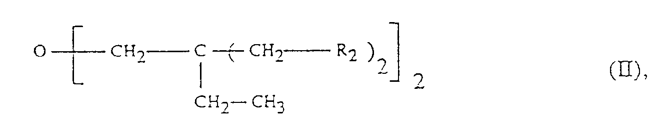
R₂―CH(̵CH₂―R₂)_{₂} (III),
où R₁ est un hydrogène ou un radical méthyle ou hydroxyle, ou un résidu de formule (IV) 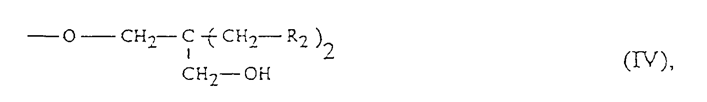 et R₂ est un groupe de formule (V) 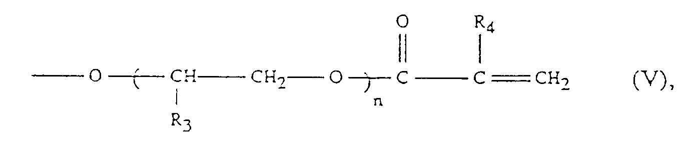 où n vaut 0, 1, 2 ou 3, et R₃ et R₄, indépendamment l'un de l'autre, sont chacun un hydrogène ou le radical méthyle, et
c) au moins un composé de formule (VI) 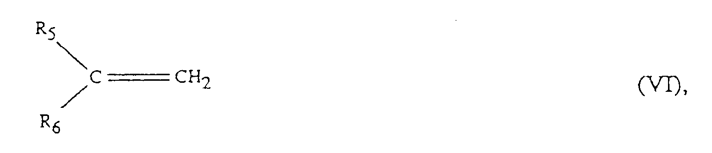 dans laquelle R₅ est un hydrogène ou le radical méthyle et R₆ est un groupe de formule (VII) 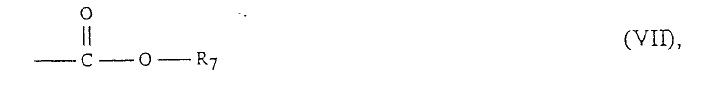 dans laquelle R₇ est choisi parmi l'ensemble comprenant les groupes tétrahydrofurfuryle, cyclohexyle, 2-phénoxyéthyle, benzyle, isobornyle, glycidyle, dicyclopentényle, morpholinoéthyle, diméthylaminoéthyle, diéthylaminoéthyle ou les radicaux alkyle en C₁-C₂₀, à chaîne droite ou ramifiée ou encore, quand R₅ est un hydrogène, R₆ peut aussi être un radical pyrrolidinone-2-yle, imidazolyle, carbazolyle, anthracényle, phényle, cycloalkyle en C₅-C₈, naphtényle, 2-norbonyle, pyridyle, N-caprolactamyle ou tolyle.

11. Procédé selon la revendication 1, caractérisé en ce que la source de lumière laser est choisie parmi l'ensemble comprenant les lasers à ion Ar, avec plusieurs raies dans les UV et/ou dans le visible, et les lasers à vapeur de cuivre.

12. Composition selon la revendication 1, destinée à être utilisée pour fabriquer des couches photopolymérisées, en particulier sous forme d'objets tridimensionnels, qui sont constituées d'une succession de couches solidifiées qui adhèrent les unes aux autres.
